# EUROPEAN PATENT APPLICATION

(11) **EP 4 439 630 A1**
(43) Date of publication of application: **02.10.2024**
(21) Application number: 24167217.9
(22) Date of filing: 28.03.2024
(51) Int. Cl.: H01L 21/02

(54) **POLYCRYSTALLINE SILICON CARBIDE SUBSTRATE AND METHOD OF MANUFACTURING THE SAME**

(30) Priority: 31.03.2023 SE 2350377
(71) Applicant: STMicroelectronics International N.V., 1228 Plan-les-Ouates, Geneva (CH)
(72) Inventor: MAGNUSSON LINDGREN, Björn, 60379 NORRKÖPING (SE); ELLISON, Alexandre, 58731 LINKOPING (SE); RIVA, Carlo, 20838 RENATE (MB) (IT)
(74) Representative: Studio Torta S.p.A.

(57) **Abstract**

At least one embodiment of a method of manufacturing includes forming a first polycrystalline silicon carbide (SiC) substrate with a sintering process by sintering one or more powdered semiconductor materials. After the first polycrystalline SiC substrate is formed utilizing the sintering process, the first polycrystalline silicon carbide SiC substrate is utilized to form a second polycrystalline SiC substrate with a chemical vapor deposition (CVD) process. The second polycrystalline SiC substrate is formed on a surface of the first polycrystalline SiC substrate by depositing SiC on the surface of the first polycrystalline SiC substrate with the CVD process. As the first and second polycrystalline SiC substrates are made of the same or similar semiconductor material (e.g., SiC), a first coefficient of thermal expansion (CTE) for the first polycrystalline SiC substrate is the same or similar to the second CTE of the second polycrystalline SiC substrate.

## Description

### BACKGROUND

### Technical Field

The present disclosure is directed to a polycrystalline silicon carbide (SiC) substrate and a method of manufacturing the same.

### Description of the Related Art

The semiconductor industry has been showing considerable interest in silicon carbide (SiC), in particular for the manufacture of electronic devices or components (e.g., diodes, transistors, or other similar power applications).

Development and manufacture of silicon carbide based electronic devices is limited by factors such as electrical and mechanical properties from forming silicon carbide wafers. At least one issue is an amount of stress or strain that a wafer undergoes when manufacturing the wafer. This stress and strain are a result of thermal mismatch between a carrier and a material which the wafer is formed from when forming the wafer on the carrier. This stress and strain may result in the propagation of mechanical defects such as cracking, warpage, chipping, breakage, or other similar or like mechanical defects that may result in the manufactured wafer being outside of selected tolerances such that the out of tolerance manufactured wafer is discarded, which increases manufacturing and waste costs. Furthermore, after the wafer is formed on the carrier, the thermal mismatch between the wafer and the carrier may result in mechanical defects propagating within the carrier, the wafer, or both when performing further processing and refinement steps (e.g., polishing, thinning, heating, etc.) to manufacture semiconductor and electronic devices due to changes in temperature *(i.e.,* increases in temperature or decreases in temperature) to which the wafer, the carrier, or both are exposed to during these additional processing and refinement steps.

### BRIEF SUMMARY

The present invention is set out in the annexed claims.

At least one embodiment of a method of manufacturing of the present disclosure includes forming a first polycrystalline silicon carbide (SiC) substrate with a sintering process by sintering a powdered semiconductor material (*e.g.,* mixture of powdered silicon (Si) and powdered carbon (C), or powdered SiC). After the first polycrystalline SiC substrate is formed utilizing the sintering process, the first polycrystalline silicon carbide SiC substrate is utilized to form a second polycrystalline SiC substrate with a chemical vapor deposition (CVD) process. The second polycrystalline SiC substrate is formed on a surface of the first polycrystalline SiC substrate by depositing SiC on the surface of the first polycrystalline SiC substrate with the CVD process. As the first and second polycrystalline SiC substrates are made of the same or similar semiconductor material (*e.g.,* SiC), a first coefficient of thermal expansion (CTE) for the first polycrystalline SiC substrate is the same or similar to the second CTE of the second polycrystalline SiC substrate.

Unlike when thermal mismatch exists between a respective carrier (*e.g.,* graphite or graphene carrier) and a respective wafer (*e.g.,* silicon carbide (SiC) wafer) formed on the respective carrier that may result in mechanical defects propagating within the respective carrier, the respective wafer, or both when performing further processing and refinement steps (*e.g.,* polishing, thinning, heating, etc.) to manufacture respective semiconductor and electronic devices, in the at least one embodiment of the method of manufacturing of the present disclosure, the first and second CTEs, respectively, of the first *(e.g.,* carrier) and second *(e.g.,* wafer) polycrystalline SiC substrates, respectively, are substantially the same (*e.g.,* equal) or similar to each other to prevent, mitigate or reduce a likelihood of propagation of mechanical defects (*e.g.,* cracks, warpage, chipping, breakage, etc.) propagating or occurring within the first and second polycrystalline SiC substrates when manufacturing the second polycrystalline SiC substrate *(e.g.,* wafer) utilizing the first polycrystalline SiC substrate (*e.g.,* carrier). For example, stresses caused by exposure to increases and decreases to heat *(i.e.,* increases in temperature or decreases in temperature) in either of the first polycrystalline SiC substrate and the second polycrystalline SiC substrate will further be mitigated in other processing and refinement steps that may occur at later stages during manufacturing. In at least one embodiment of a method of manufacturing the second polycrystalline SiC substrate, the first polycrystalline SiC substrate may be ground down such that a surface of the second polycrystalline SiC substrate is exposed. This grinding process may result in increases in temperature in both the first and second polycrystalline SiC substrate; however, since the first and second CTEs are the same or similar, any propagation of mechanical defects will prevented or reduced in likelihood of propagating.

In view of the above discussion, the embodiments of the present disclosure prevent, mitigate, or reduce the likelihood of mechanical defects propagating within the first and second polycrystalline SiC substrates when forming the second polycrystalline SiC substrate utilizing the first polycrystalline SiC substrate. Also, in view of the above discussion, the embodiments of the present disclosure both prevent or recduce the likelihood of mechanical defects propagating within the first and second polycrystalline SiC substrates when further refining or processing the first ands second polycrystalline SiC substrates.

### BRIEF DESCRIPTION OF THE SEVERAL VIEWS OF THE DRAWINGS

Figure 1 is a flowchart of an embodiment of a method of forming or manufacturing a carrier polycrystalline SiC substrate and a method of forming or manufacturing a polycrystalline SiC substrate utilizing the carrier polycrystalline SiC substrate;
Figures 2A-2C are side views of respective intermediate structures during the embodiment of the method of forming the carrier polycrystalline SiC substrate and the method of forming the polycrystalline SiC substrate utilizing the carrier polycrystalline SiC substrate;
Figure 3 is a perspective side view of an embodiment of the carrier polycrystalline SiC substrate utilized to form the polycrystalline SiC substrate;
Figure 4 is a perspective side view of an embodiment of the polycrystalline SiC substrate on the embodiment of the carrier polycrystalline SiC substrate as shown in Figure 3; and
Figure 5 is a perspective side view of the embodiment of polycrystalline SiC substrate.

### DETAILED DESCRIPTION

At least one embodiment of a method of forming or manufacturing of the present disclosure includes forming a first polycrystalline silicon carbide (SiC) substrate with a sintering process by sintering a powdered semiconductor material (*e.g.,* mixture of powdered silicon (Si) and powdered carbon (C), or powdered SiC). After the first polycrystalline SiC substrate is formed utilizing the sintering process, the first polycrystalline silicon carbide SiC substrate is utilized to form a second polycrystalline SiC substrate with a chemical vapor deposition (CVD) process. The second polycrystalline SiC substrate is formed on a surface of the first polycrystalline SiC substrate by depositing SiC on the surface of the first polycrystalline SiC substrate with the CVD process. As the first and second polycrystalline SiC substrates are made of the same or similar semiconductor material (*e.g.,* SiC), a first coefficient of thermal expansion (CTE) for the first polycrystalline SiC substrate is the same or similar to the second CTE of the second polycrystalline SiC substrate. These first and second CTEs being the same or similar prevents or reduces a likelihood of propagation of mechanical defects (*e.g.,* cracks, warpage, etc.) present within the second polycrystalline SiC substrate when manufacturing the second polycrystalline SiC substrate utilizing the first polycrystalline SiC substrate.

During the CVD process to form the second polycrystalline SiC substrate, the first polycrystalline SiC substrate is exposed to heat that causes the first polycrystalline SiC substrate to thermally expand *(i.e.,* increase in volume). While forming the second polycrystalline SiC substrate on the first polycrystalline SiC substrate, the SiC being deposited on the surface of the first polycrystalline SiC substrate is exposed to heat that causes the SiC being deposited on the surface of the first polycrystalline SiC substrate to thermally expand. As the first polycrystalline SiC substrate is made of SiC and the second polycrystalline SiC substrate is being formed of SiC, the first polycrystalline SiC substrate and the SiC being utilized to form the polycrystalline SiC substrate have the same or similar coefficient of thermal expansion (CTE). Since expansion in both the first polycrystalline SiC substrate and the SiC being utilized to form the second polycrystalline SiC substrate have the same or similar thermal expansion when exposed to heat, stress and strain in the first polycrystalline SiC substrate and the SiC being utilized to form the second polycrystalline SiC substrate is mitigated preventing or reducing a likelihood of propagation of mechanical defects within the second polycrystalline SiC substrate when forming the second polycrystalline SiC substrate.

This same or similar CTE results in the first polycrystalline SiC substrate and the SiC being utilized to form the second polycrystalline SiC substrate to have the same or similar thermal expansion when exposed to heat *(i.e.,* increase in temperature) or have the same or similar thermal contraction when being cooled (*i.e.,* decrease in temperature). This similarity between the thermal expansion and contraction of the first and second polycrystalline SiC substrates prevents or reduces the likelihood of propagation of mechanical defects within the second polycrystalline SiC substrate when forming the second polycrystalline SiC substrate utilizing the first polycrystalline SiC substrate. For example, if the first polycrystalline SiC substrate was replaced with a graphite or graphene substrate on which the second polycrystalline SiC substrate was formed, the graphite or graphene substrate would have a third CTE that is different from the second CTE of the second polycrystalline SiC substrate. This difference in the second CTE and the third CTE would result in more significant differences between thermal expansion and contraction of the graphite or graphene substrate and the second polycrystalline SiC substrate relative to when the second polycrystalline SiC substrate is formed utilizing the first polycrystalline SiC substrate. This greater difference in thermal expansion between the graphite or graphene substrate and the second polycrystalline SiC substrate results in an increased likelihood of mechanical defects propagating within the second polycrystalline SiC substrate when forming the second polycrystalline SiC substrate due to an increase in stresses or strains as a result of these differences in thermal expansion and contraction between the graphite or graphene substrate and the second polycrystalline SiC substrate. In view of this discussion, forming the second polycrystalline SiC substrate with the second CTE on the first polycrystalline SiC substrate with the first CTE, which may be the same or similar to the second CTE, prevents or reduces the likelihood of propagation of mechanical defects (*e.g.,* cracking, warpage, etc.) being present within the manufactured second polycrystalline SiC substrates when utilizing the at least one embodiment of the method of forming or manufacturing of the present disclosure.

Once the second polycrystalline SiC substrate is formed on the surface of the first polycrystalline SiC substrate, the first and second polycrystalline SiC substrates are allowed to cool down resulting in the first and second polycrystalline SiC substrates to thermally contract (*i.e*., reduce in volume). As the first and second polycrystalline SiC substrates have the first and second CTEs, which are the same or similar to each other, the first and second polycrystalline SiC substrates thermally contract by the same or similar amount as the first and second polycrystalline SiC substrates are cooled. This similarity between the thermal contraction of the first and second polycrystalline SiC substrates prevents or reduces the likelihood of propagation of mechanical defects within the second polycrystalline SiC substrate when forming the second polycrystalline SiC substrate. For example, if the first polycrystalline SiC substrate was replaced with a graphite or graphene substrate on which the second polycrystalline SiC substrate was formed, the graphite or graphene substrate would have a third CTE that is different from the second CTE of the second polycrystalline SiC substrate. This difference in the second CTE and the third CTE results in more significant differences between thermal contraction of the graphite or graphene substrate and the second polycrystalline SiC substrate relative to when the second polycrystalline SiC substrate is formed utilizing the first polycrystalline SiC substrate. This difference in thermal contraction between the graphite or graphene substrate and the second polycrystalline SiC substrate results in an increased likelihood of mechanical defects propagating within the second polycrystalline SiC substrate when forming the second polycrystalline SiC substrate due to an increase in stresses or strains as a result of these differences in thermal contraction between the graphite or graphene substrate and the second polycrystalline SiC substrate. In view of this discussion, forming the second polycrystalline SiC substrate with the second CTE on the first polycrystalline SiC substrate with the first CTE, which may be the same or similar to the second CTE, prevents or reduces the likelihood of propagation of mechanical defects (*e.g.,* cracking, warpage, etc.) being present within the manufactured second polycrystalline SiC substrates when utilizing the at least one embodiment of the method of manufacturing of the present disclosure.

At least one embodiment of a method of the present disclosure is summarized as follows. The method includes forming a carrier polycrystalline silicon carbide (SiC) substrate having a surface. Forming the carrier polycrystalline SiC substrate includes sintering one or more powdered materials to form the carrier polycrystalline SiC substrate, and forming a polycrystalline SiC substrate on the surface of the carrier polycrystalline SiC substrate, forming the polycrystalline SiC substrate including depositing SiC onto the surface of the carrier polycrystalline SiC substrate with a chemical vapor deposition (CVD) process.

At least one embodiment of a device of the present disclosure is summarized as follows. The device includes a first polycrystalline SiC substrate including a first surface and a second surface opposite to the first surface, and a second polycrystalline SiC substrate coupled to the second surface of the first polycrystalline SiC substrate.

At least one embodiment of a method of the present disclosure is summarized as follows. The method including forming a polycrystalline SiC substrate with a first coefficient of thermal expansion on a first surface of a polycrystalline SiC carrier substrate with a second coefficient of thermal expansion substantially equal to the first coefficient of thermal expansion, forming the polycrystalline SiC substrate includes forming a second surface of the polycrystalline SiC substrate facing away from the carrier polycrystalline SiC substrate. After forming the polycrystalline SiC substrate, removing the polycrystalline SiC substrate from the carrier polycrystalline SiC substrate.

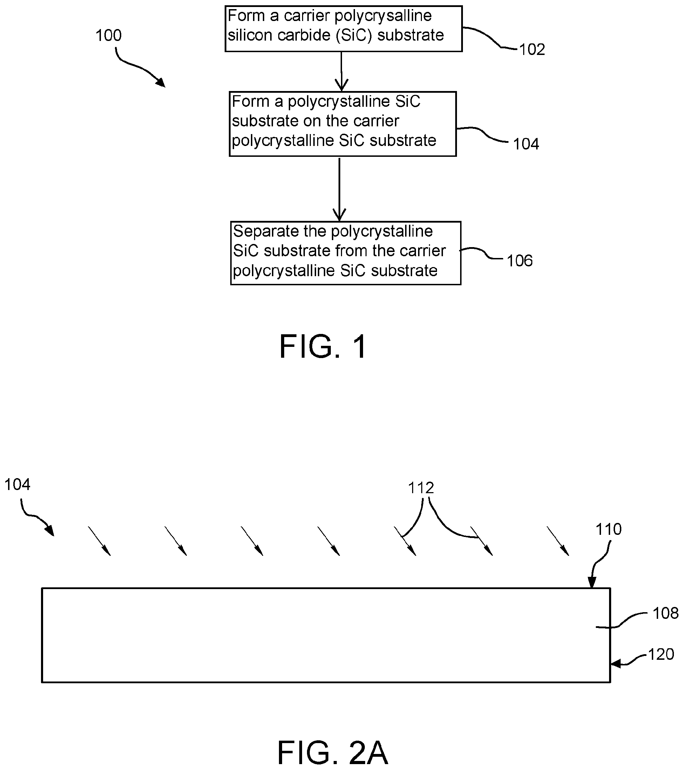

Figure 1 is a flowchart 100 of an embodiment of a method of manufacturing a polycrystalline SiC substrate 114 utilizing a carrier polycrystalline SiC substrate 108, which may have been formed utilizing a sintering process, to manufacture the polycrystalline SiC substrate 114. As shown in the flowchart 100 in Figure 1, the flowchart 100 includes a first step 102 (*i.e.,* upper step based on the orientation of the flowchart), a second step 104 (*i.e.,* intermediate step based on the orientation of the flowchart), and a third step 106 (*i.e.,* lower step based on the orientation of the flowchart).

In the first step 102, the carrier polycrystalline SiC substrate 108 is formed, which may be formed utilizing a sintering process. The carrier polycrystalline SiC substrate 108 may be a support substrate, a carrier substrate, a support wafer, a carrier wafer, a dummy wafer, or some other similar type of wafer or substrate. In at least one embodiment, the carrier polycrystalline SiC substrate 108 is formed by a sintering process. Utilizing this sintering process to form the carrier polycrystalline SiC substrate 108 may be cheaper than forming the carrier polycrystalline SiC substrate 108 with another method such as, for example, a chemical vapor deposition (CVD) process or some other known substrate manufacturing technique. For example, when this sintering process is utilized to form the carrier polycrystalline SiC substrate 108, a sintering furnace is utilized to sinter together a mixture of powdered silicon (Si) and powdered carbon (C) forming the carrier polycrystalline SiC substrate 108 or utilizing the furnace to sinter together powered silicon carbide (SiC) forming the carrier polycrystalline SiC substrate 108. In other words, the carrier polycrystalline SiC substrate 108 may be formed utilizing sintering processes known within the silicon carbide (SiC) substrate manufacturing industry. The carrier polycrystalline SiC substrate 108 may be seen in Figures 2A, 2B, 3, and 4 of the present disclosure, which will be discussed in detail later herein.

After the carrier polycrystalline SiC substrate 108 is formed in the first step, the carrier polycrystalline SiC substrate 108 is allowed to cool down and is removed from the sintering furnace. After the carrier polycrystalline SiC substrate 108 has cooled and has been removed from the sintering furnace, the carrier polycrystalline SiC substrate 108 is positioned within a chamber of a chemical vapor deposition (CVD) tool.

In an alternative embodiment, the carrier polycrystalline SiC substrate 108 may be formed from a sintered body that was previously formed utilizing the above sintering process. After the sintered body is formed, the carrier polycrystalline SiC substrate 108 may be formed by refining all of or a portion of the sintered body to form the carrier polycrystalline SiC substrate 108. For example, in some embodiments, after the sintered body is formed, a portion of the sintered body may be split or cut away from the sintered body and the portion of the sintered body may be polished, grinded, or undergo further processing and refinement steps or combination of processing and refinement steps to be processed and refined into the carrier polycrystalline SiC substrate 108. For example, in some alternative embodiments, after the sintered body is formed, the sintered body may be polished, grinded, or undergo further processing and refinement steps or combination of processing and refinement steps to be processed and refined into the carrier polycrystalline SiC substrate 108.

The carrier polycrystalline SiC substrate 108 has a cubic structure. For example, the carrier polycrystalline SiC substrate 108 has a 3C-SiC structure. The carrier polycrystalline SiC substrate 108 may have a resistivity less than or equal to 500 mohm-cm or preferably in the range from 25 to 250 mohm-cm or equal to the upper and lower ends of this range.

After the carrier polycrystalline SiC substrate 108 is positioned within the chamber of the CVD tool, the second step 104 of the flowchart 100 as shown in Figure 1 is carried out in which the polycrystalline SiC substrate 114 is formed on the carrier polycrystalline SiC substrate 108. As shown in Figure 2A, the CVD process is performed such that SiC is formed on a surface 110 of the carrier polycrystalline SiC substrate 108. The surface 110 of the carrier polycrystalline SiC substrate 108 is a sintered surface. This surface 110 of the carrier polycrystalline SiC substrate 108 is an upper surface of the carrier polycrystalline SiC substrate 108 based on the orientation of the carrier polycrystalline SiC substrate 108 as shown in Figure 2A.

In some embodiments, before the polycrystalline SiC substrate 114 is formed on the surface 110 of the carrier polycrystalline SiC substrate 108, the surface 110 of the carrier polycrystalline SiC substrate 108 may be polished. In some alternative embodiments, the polycrystalline SiC substrate 114 is formed on the surface 110 of the carrier polycrystalline SiC substrate 108 without polishing the surface 110 of the carrier polycrystalline SiC substrate 108 such that the surface 110 of the carrier polycrystalline SiC surface 108 may be rough as compared to when the surface 110 is instead polished. In yet some other alternative embodiments, when the carrier polycrystalline SiC substrate 108 is formed by cutting away a portion of a sintered body (see discussion earlier herein), the surface 110 of the carrier polycrystalline SiC substrate 108 may be a surface that was formed by cutting the portion away from the sintered body to form the carrier polycrystalline SiC substrate 108 such that the surface 110 of the carrier polycrystalline SiC substrate 108 is a cut surface. In other words, the surface 110 of the carrier polycrystalline SiC substrate 108 may be a polished surface, a rough surface as compared to when the surface 110 is polished, a sintered surface, a cut surface, or some other type of respective surface on which the polycrystalline SiC substrate 114 may be formed.

The polycrystalline SiC substrate 114 may have a resistivity less than or equal to 10 mohm-cm or preferably in the range from 1 to 5 mohm-cm or equal to the upper and lower ends of this range.

The formation or deposition of the SiC on the surface 110 of the carrier polycrystalline SiC substrate 108 to form the polycrystalline SiC substrate 114 on the carrier polycrystalline SiC substrate 108 is represented by respective arrows 112 as shown in Figure 2A. For example, in at least one embodiment of this CVD process to form the polycrystalline SiC substrate 114 on the carrier polycrystalline SiC substrate 108, silicon carbide (SiC) or silicon (Si) and carbon (C) particles or atoms are introduced to the surface 110 of the carrier polycrystalline SiC substrate 108. Over time, these atoms or particles build up on the surface 110 of the carrier polycrystalline SiC substrate 108 forming the polycrystalline SiC substrate 110.

This CVD process to form the polycrystalline SiC substrate 114 on the carrier polycrystalline SiC substrate 108 exposes the carrier polycrystalline SiC substrate 108 and the SiC or Si and C particles and atoms to heat such that the carrier polycrystalline SiC substrate 108 and the SiC or Si and C particles expand during manufacturing of the polycrystalline SiC substrate 114 on the carrier polycrystalline SiC substrate 108. However, since the carrier polycrystalline SiC substrate 108 and the polycrystalline SiC substrate 114 being formed on the surface 110 of the carrier polycrystalline SiC substrate 108 are made of a silicon carbide material, a first coefficient of thermal expansion (CTE) of the carrier polycrystalline SiC substrate 108 is substantially equal to or similar to a second CTE of the polycrystalline SiC substrate 114 being formed on the surface 110 of the carrier polycrystalline SiC substrate 108. Since the first CTE and the second CTE are substantially equal to each other, the carrier polycrystalline SiC substrate 108 and the polycrystalline SiC substrate 114 being formed on the surface of the carrier polycrystalline SiC substrate 108 expand by substantially the same or similar amount as each other when exposed to heat during this CVD process.

This same or similar expansion between the carrier polycrystalline SiC substrate 108 and the polycrystalline SiC substrate 114 when forming the polycrystalline SIC substrate 114 on the carrier polycrystalline SiC substrate 108 prevents or reduces a likelihood of mechanical defects propagating within the polycrystalline SiC substrate 114 when forming the polycrystalline SiC substrate 114. As the carrier polycrystalline SiC substrate 108 and the polycrystalline SiC substrate 114 expand by substantially the same or similar amounts, stresses and strains that occur due to any minor thermal expansion differences between the carrier polycrystalline SiC substrate 108 and the polycrystalline SiC substrate 114 are relatively low. For example and in the alternative, if a first substrate (*e.g.,* a graphite or graphene substrate) has a first CTE that is significantly different than a second CTE of a second substrate (*e.g.,* a silicon carbide (SiC) substrate) that is being formed on the first substrate, thermal expansion differences, which may be referred to as thermal mismatch, between the first and second substrates when forming the second substrate result in large amount of stresses and strains occurring within the second substrate. This increase or high stress and strain occurring within the second substrate due to the differences in thermal expansion in the first and second substrates when forming the second substrate increases the likelihood of mechanical defects (*e.g.,* cracking, warpage, etc.) propagating within the second substrate when forming the second substrate. In view of this discussion, as the carrier polycrystalline SiC substrate 108 and the polycrystalline SiC substrate 114 being formed on the carrier polycrystalline SiC substrate 108 have CTEs that are substantially equal to each other, the thermal expansion of the carrier polycrystalline SiC substrate 108 and the polycrystalline SiC substrate 114 will be substantially the same preventing or reducing the likelihood of mechanical defects propagating within the polycrystalline SiC substrate 114 when forming the polycrystalline SiC substrate 114. Preventing or reducing the likelihood of mechanical defects propagating within the polycrystalline SiC substrate 114 when forming the polycrystalline SiC substrate 114 reduces waste costs and manufacturing costs as fewer defective polycrystalline SiC substrates 114 formed outside of selected tolerances are manufactured, which, in turn, increases a yield number when manufacturing the polycrystalline SiC substrates 114.

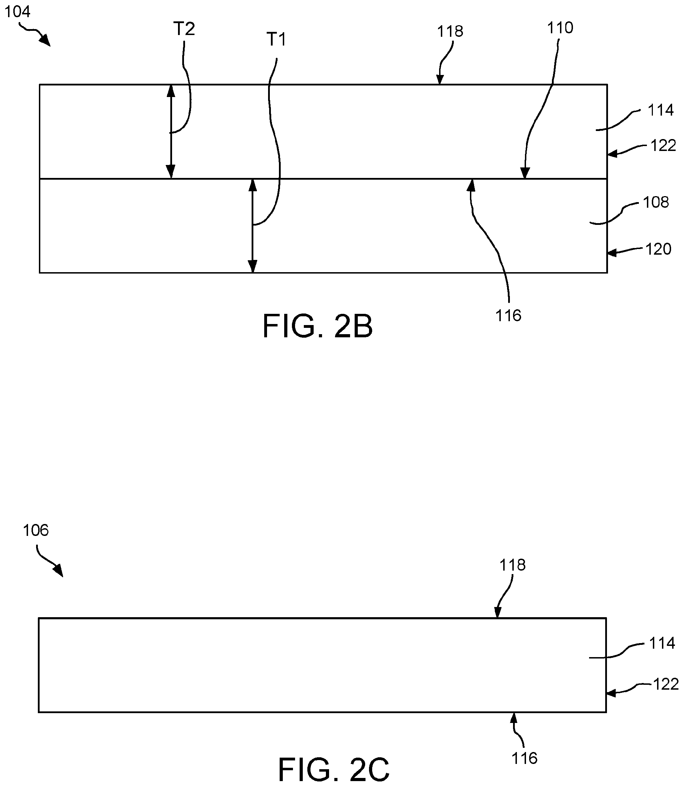

The results of this CVD process may be seen in Figure 2B in which the polycrystalline SiC substrate 114 is present on the surface 110 of the carrier polycrystalline SiC substrate 108. In at least one embodiment, a first thickness T1 of the carrier polycrystalline SiC substrate 108 may be substantially equal to or the same as a second thickness T2 of the polycrystalline SiC substrate 114. In some alternative embodiments, the first thickness T1 of the carrier polycrystalline SiC substrate 108 may be greater than the second thickness T2 of the polycrystalline SiC substrate 114 such that the polycrystalline SiC substrate 114 is thinner than the carrier polycrystalline SiC substrate 108.

The first thickness T1 may be within a range from 200 micrometers (µm) to 1500 micrometers (µm), or may be equal to the upper and lower ends of this range. In some embodiments, the second thickness T2 may be within a range from 80 micrometers to 180 micrometers, or may be equal to the upper and lower ends of this range. In some embodiments, the second thickness T2 may be within a range from 120 micrometers to 180 micrometers, or may be equal to the upper and lower ends of this range. The second thickness T2 may be less than or equal to 300 micrometers. However, it will readily appreciated that this process may be adapted to form the polycrystalline SiC substrate 114 with different varying thicknesses depending on the use and application in which the polycrystalline SiC substrate 114 is to be utilized.

After the polycrystalline SiC substrate 114 is formed on the surface 110 of the carrier polycrystalline SiC substrate 108 as shown in Figure 2B, the polycrystalline SiC substrate 114 and the carrier polycrystalline SiC substrate 108 are allowed to cool down after completion of the CVD process. As the first CTE of the carrier polycrystalline SiC substrate 108 and the second CTE of the polycrystalline SiC substrate 114 is substantially the same or equal to each other, the carrier polycrystalline SiC substrate 108 and the polycrystalline SiC substrate 114 thermally contract by substantially the same or equal amount. As the carrier polycrystalline SiC substrate 108 and the polycrystalline SiC substrate 114 contract by substantially the same or similar amounts, stresses and strains that occur due to any minor thermal contraction differences between the carrier polycrystalline SiC substrate 108 and the polycrystalline SiC substrate 114 are relatively low. For example and in the alternative, if a first substrate (*e.g.,* a graphite or graphene substrate) has a first CTE that is significantly different than a second CTE of a second substrate (*e.g.,* a silicon carbide (SiC) substrate) that is being formed on the first substrate, thermal contraction differences, which may be referred to as thermal mismatch, between the first and second substrates when forming the second substrate result in large amount of stresses and strains occurring within the second substrate. This increase or high stress and strain occurring within the second substrate due to the differences in thermal contraction in the first and second substrates when cooling the first and second substrates increases the likelihood of mechanical defects (*e.g.,* cracking, warpage, etc.) propagating within the second substrate when cooling the first and second substrates. In view of this discussion, as the carrier polycrystalline SiC substrate 108 and the polycrystalline SiC substrate 114 being formed on the carrier polycrystalline SiC substrate 108 have CTEs that are substantially equal to each other, the thermal contraction of the carrier polycrystalline SiC substrate 108 and the polycrystalline SiC substrate 114 will be substantially the same preventing or reducing the likelihood of mechanical defects propagating within the polycrystalline SiC substrate 114 when cooling the polycrystalline SiC substrate 114 and the carrier polycrystalline SiC substrate 108. Preventing or reducing the likelihood of mechanical defects propagating within the polycrystalline SIC substrate 114 when forming the polycrystalline SiC substrate 114 reduces waste costs and manufacturing costs as fewer defective polycrystalline SIC substrates 114 formed outside of selected tolerances are manufactured, which, in turn, increases a yield number when manufacturing the polycrystalline SiC substrates 114.

The polycrystalline SiC substrate 114 is formed to have a cubic structure the same or similar to the cubic structure of the carrier polycrystalline SiC substate 108.

After the second step in which the polycrystalline SiC substrate 114 is formed on the surface 110 of the carrier polycrystalline SiC substrate 108 utilizing the CVD process or technique, in a third step of the flowchart 100 as shown in Figure 1, the polycrystalline SiC substrate 114 is removed from the carrier polycrystalline SiC substrate 108. For example, the polycrystalline SiC substrate 108 may be removed from the carrier polycrystalline SiC substrate 114 by removing (*e.g.,* grinding away) the carrier polycrystalline SiC substrate 114 to expose a surface 116 of the polycrystalline SiC substrate 114 previously on the surface 110 of the carrier polycrystalline SiC substrate 108 on which the polycrystalline SiC substrate 114 was formed. The results of this removal step may be seen in Figure 2C in which the polycrystalline SiC substrate 114 remains and has been removed from the carrier polycrystalline SiC substrate 108. In other words, Figure 2C is a side view of the polycrystalline SiC substrate 114 after being removed from the carrier polycrystalline SiC substrate 108. In some alternative embodiments of the method of forming or manufacturing the polycrystalline SiC substrate 114, the polycrystalline SiC substrate 114 may be removed from the carrier polycrystalline SiC substrate 108 by another technique such as, for example, a splitting technique, a cutting technique, or some other type of technique to remove the polycrystalline SiC substrate 114 from the carrier polycrystalline SiC substrate 108.

In some embodiments, the polycrystalline SiC substrate 114 has a diameter within a range from 150 millimeters to 300 millimeters, or the diameter may be equal to the upper and lower ends of this range. In some embodiments, the diameter may be substantially equal to 200 millimeters.

The polycrystalline SiC substrate 114 has a cubic structure. For example, in at least one embodiment the polycrystalline SiC substrate 114 is made up of 90% or more 3C-SiC, or in a preferred embodiment made up of 95% or more 3C-SiC. The remaining part of the polycrystalline SiC substrate if existing or present is made up of polytypes such as, for example, 4H-SiC, 6H-SiC, and 15R-SiC, and no polytypes are present larger than a unit cell greater than 15.

In an alternative embodiment of the method of forming or manufacturing the polycrystalline SiC substrate 114, the polycrystalline SiC substrate 114 may remain coupled to the carrier polycrystalline SiC substrate 108 instead of being separated from the carrier polycrystalline SiC substrate 108.

In some embodiments, a surface 118 of the polycrystalline SiC substrate 114 that faces away from the carrier polycrystalline SiC substrate 108 may be polished by a chemical mechanical polishing technique such that the surface 118 of the polycrystalline SiC substrate 114 that faces away from the carrier polycrystalline SiC substrate 108 has a roughness less than or equal to 2 nm (20 angstroms, Å). In some embodiments, the surface 118 of the polycrystalline SiC substrate 114 facing away from the carrier polycrystalline SiC substrate 108 may be polished to have a roughness less than or equal to 0.5 nm (5 angstroms, Å). In some embodiments, an opposite surface 116 of the polycrystalline SiC substrate 114 opposite to the surface 118 of the polycrystalline SiC substrate 114 that faces away from the carrier polycrystalline SiC substrate 108 may be polished to have a roughness less than or equal to 2 nm (20 angstroms, Å). In some embodiments, the opposite surface 116 of the polycrystalline SiC substrate 108 may be polished to have a roughness less than or equal to 0.5 nm ( 5angstroms, Å).

The polycrystalline SiC substrate 114 has the second thickness that T2 that extends from the opposite surface 116 of the polycrystalline SiC substrate 114 to the surface 118 of the polycrystalline SiC substrate 114. In some embodiments, the second thickness T2 of the polycrystalline SiC substrate 114 is less than or equal to 150 micrometers (µm). In some embodiments, the second thickness T2 may be within the range of 50 micrometers (µm) to 150 micrometers (µm) or may be equal to the upper and lower ends of this range (*i.e.,* equal to 50 micrometers (µm) or equal to 150 micrometers (µm)). In some embodiments, the second thickness T2 may be within the range of 100 micrometers (µm) to 150 micrometers (µm) or may be equal to the upper and lower ends of this range (*i.e.,* equal to 100 micrometers (µm) or equal to 150 micrometers (µm)). In some embodiments, the second thickness T2 of the polycrystalline SiC substrate 114 may be equal to 150 micrometers (µm).

In some embodiments, the polycrystalline SiC substrate 114 is formed to have a density greater than the carrier polycrystalline SiC substrate 108. In some embodiments, the polycrystalline SiC substrate 114 may have a density the same or similar to a monocrystalline SiC substrate, which may later be formed on the polycrystalline SiC substrate 114.

In some embodiments, the opposite surface 116 of the polycrystalline SiC substrate 114, which was previously coupled to the surface 110 of the carrier polycrystalline SiC substrate 108 before removing the carrier polycrystalline SiC substrate 108 from the polycrystalline SiC substrate 114, may be polished. For example, when the opposite surface 116 of the polycrystalline SiC substrate 114 that was previously coupled to the carrier polycrystalline SiC substrate 108 is polished, the opposite surface 116 of the polycrystalline SiC substrate 114 previously coupled to the carrier polycrystalline SiC substrate 108 may have a roughness less than or equal to 2 nm (20 angstroms, Å). In some embodiments, the opposite surface 116 of the polycrystalline SiC substrate 114 previously coupled to the carrier polycrystalline SiC substrate 108 may be polished to have a roughness less than or equal to 0.5 nm (5 angstroms, Å).

After the polycrystalline SiC substrate 114 has been formed, further semiconductor materials, dielectric materials, conductive materials, or non-conductive materials may be formed on the polycrystalline SiC substrate 108 in manufacturing various electronic devices. For example, these electronic devices may include semiconductor dice, semiconductor packages, or some other similar type of semiconductor or electrical devices. For example, in at least one embodiment, a further semiconductor material may be a monocrystalline SiC substrate or layer that is formed on the surface 118 of the polycrystalline SiC substrate 114 that faces away from the carrier polycrystalline SiC substrate 108. In some embodiments, the monocrystalline SiC substrate or layer may be physically and directly bonded to the surface 118 of the polycrystalline SiC substrate 114 that faces away from the carrier polycrystalline SiC substrate 108. In some embodiments, a bond layer may be present between the monocrystalline SiC substrate or layer and the surface 118 of the polycrystalline SIC substrate 114 that faces away from the carrier polycrystalline SiC substrate 108. For example, in some embodiments, the bond layer may be an adhesive or may be some other suitable type of bond layer that bonds or couples the monocrystalline SiC substrate or layer to the polycrystalline SiC substrate or layer 114.

For example, in so called direct bonded SiC substrates, the monocrystalline SiC substrate or layer may be bonded to, coupled to, or formed on the surface 118 of the polycrystalline SiC substrate 114 that faces away from the carrier polycrystalline SiC substrate 108. In some embodiments, when the monocrystalline SiC substrate or layer is a monocrystalline SiC substrate, the monocrystalline SiC substrate may be bonded to or coupled to the surface 118 of the polycrystalline SiC substrate 114 that faces away from the carrier polycrystalline SiC substrate 108. In some embodiments, the monocrystalline SiC substrate may be coupled to the surface 118 of the polycrystalline SiC substrate 114 that faces away from the carrier polycrystalline SiC substrate 108 by a bonding layer, which may be, for example, an adhesive or some other suitable type of material for coupling the monocrystalline SiC substrate to the surface 118 of the polycrystalline SiC substrate 114.

In some embodiments, the monocrystalline SiC substrate may have previously been split from a thicker monocrystalline SiC base substrate such that the monocrystalline SiC substrate bonded or coupled to the surface 118 of the polycrystalline SIC substrate 114 has a thickness less than or equal to 1 micrometer (µm), which is less than the thickness of the thicker monocrystalline SiC base substrate from which the monocrystalline SiC substrate was split. In other words, the thicker monocrystalline SiC base substrate may be split multiple times (*e.g.,* 10 to 50 times) such that multiples of the thinner monocrystalline SiC substrates are formed and are then coupled to multiple respective ones of respective surfaces 118 of respective polycrystalline SiC substrates 114 that face away from respective carrier polycrystalline SiC substrates 108.

Forming and utilizing the at least one embodiment of the polycrystalline SiC substrate 114 in forming electronic devices and semiconductor packages reduces an "on" resistivity (Rₒₙ) of electronic devices and semiconductor devices. Reducing the "on" resistivity (Rₒₙ) reduces resistance such that electrical signals are less impeded when passing through the polycrystalline SiC substrate 114 within the electronic devices and semiconductor devices in which the polycrystalline SIC substrate 114 is incorporated and present.

In view of the above discussion, as the first CTE of the carrier polycrystalline SiC substrate 108 is substantially the same or equal to the second CTE of the polycrystalline SiC substrate 114 formed on the carrier polycrystalline SiC substrate 108, the polycrystalline SiC substrate 114 may be formed much thinner relative to when a carrier substrate is instead made of a different material that has a different CTE from the first and second CTEs.

Utilizing the method in the flowchart 100 as shown in Figure 1 to form the polycrystalline SiC substrate 114 on the carrier polycrystalline SiC substrate 108 in manufacturing the polycrystalline SiC substrate 114 maintains warpage within the polycrystalline SiC substrate 114, the carrier polycrystalline SiC substrate 108, or both below or equal to 75 micrometers (µm).

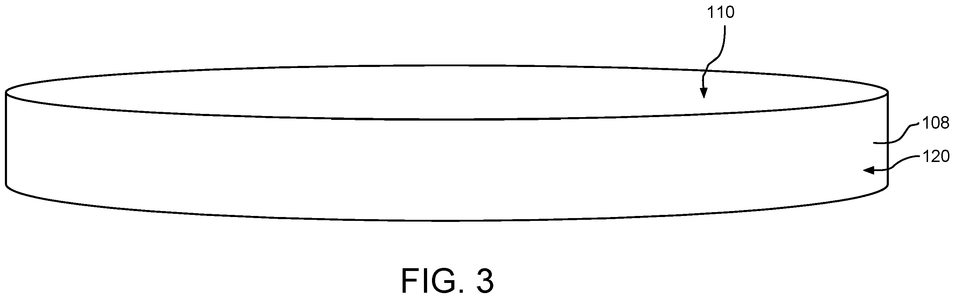

Figure 3 illustrates a perspective view of the carrier polycrystalline SiC substrate 108 including a first surface 110 (*i.e.,* the surface 110) and a second surface 119 opposite to the first surface 110. The first surface 110 is the surface 110 on which the polycrystalline SiC substrate 114 is to be formed on the carrier polycrystalline SiC substrate 108. The polycrystalline SiC substrate 114 may be formed on the carrier polycrystalline SiC substrate 108 utilizing the method present within the flowchart 100 as shown in Figure 1. The carrier polycrystalline SiC substrate 108 includes a first sidewall 120 that is transverse to the first and second surfaces 110, 119 and extends from the first surface 110 to the second surface 119. In the embodiment as shown in Figure 3, the carrier polycrystalline SiC substrate 108 has a cylindrical profile. However, in some alternative embodiments, the carrier polycrystalline SiC substrate 108 may have some other type of 3D polygonal profile or some other type of 3D profile.

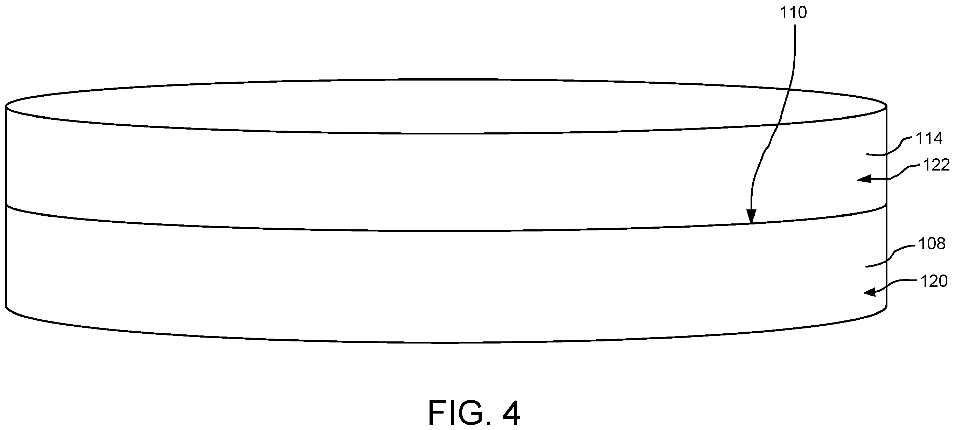

Figure 4 illustrates a perspective view of a stacked polycrystalline SiC assembly in which the polycrystalline SiC substrate 114 has been formed on the first surface 110 of the carrier polycrystalline SiC substrate 108 such that the polycrystalline SiC substrate 114 is coupled to the first surface 110 of the carrier polycrystalline SiC substrate 108. The polycrystalline SiC substrate 114 has a third surface 116 *(i.e.,* the opposite surface 116) coupled to the first surface 110 of the carrier polycrystalline SiC substrate 108 and a fourth surface 118 *(i.e.,* the surface 118) that faces away from the carrier polycrystalline SiC substrate 108. The fourth surface 118 may be the surface 118 of the polycrystalline SiC substrate 114 that faces away from the carrier polycrystalline SiC substrate 108 that may be polished as discussed above. The second surface 119 of the carrier polycrystalline SiC substrate 108 faces away from the polycrystalline SiC substrate 114. In the embodiment as shown in Figure 4, the first thickness T1 of the carrier polycrystalline SiC substrate 108 is substantially equal to the second thickness T2 of the polycrystalline SiC substrate 114. In some alternative embodiments, the first thickness T1 may be less than or greater than the second thickness T2 or the first thickness Tlmay be greater than the second thickness T2. The polycrystalline SiC substrate 114 includes a second sidewall 122 that is transverse to the third surface 116 and the fourth surface 118, and the second sidewall 122 extends from the third surface 116 to the fourth surface 118. The second sidewall 122 of the polycrystalline SiC substrate 114 is coplanar with the first sidewall 120 of the carrier polycrystalline SiC substrate 108.

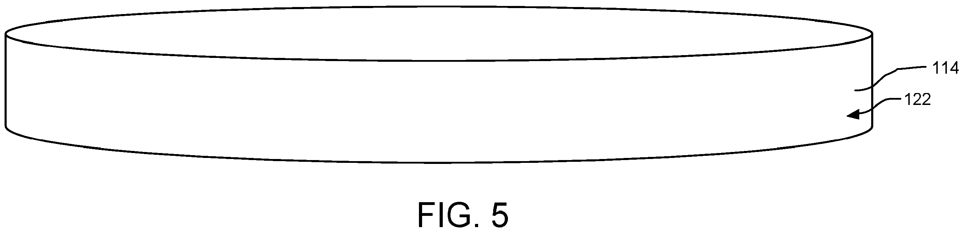

Figure 5 is a perspective view of an embodiment of the polycrystalline SiC substrate 114 after the carrier polycrystalline SiC substrate 108 has been removed from the third surface 116 of the polycrystalline SiC substrate 114. After the carrier polycrystalline SiC substrate 108 has been removed from the polycrystalline SiC substrate 114, various ones of respective surfaces 116, 118 of the polycrystalline SiC substrate 114 may be polished to have a roughness less than or equal to 2 nm (20 angstroms, Å). In some embodiments, after the carrier polycrystalline SiC substrate 108 has been removed from the polycrystalline SiC substrate 114, various ones of respective surfaces 116, 118 of the polycrystalline SiC substrate 114 may be polished to have a roughness less than or equal to 0.5 nm (5 angstroms, Å).

At least one embodiment of a method of the present disclosure may be summarized as including: forming a carrier polycrystalline silicon carbide (SiC) substrate having a surface, forming the carrier polycrystalline SiC substrate including: sintering one or more powdered materials to form the carrier polycrystalline SiC substrate; forming a polycrystalline SiC substrate on the surface of the carrier polycrystalline SiC substrate including: depositing SiC onto the surface of the carrier polycrystalline SiC substrate with a chemical vapor deposition (CVD) process.

The method may further include cooling the polycrystalline SiC substrate and the carrier polycrystalline SiC substrate.

The carrier polycrystalline SiC substrate may have a first coefficient of thermal expansion (CTE) and the polycrystalline SiC substrate may have a second CTE, and the first CTE may be substantially equal to the second CTE.

The method may further include polishing a surface of the polycrystalline SiC substrate facing away from the surface of the carrier polycrystalline SiC substrate to have a roughness less than or equal to 0.5 nm (5 angstroms, Å).

The method may further include removing the polycrystalline SiC substrate from the carrier polycrystalline SiC substrate.

Removing the polycrystalline SiC substrate from the carrier polycrystalline SiC substrate may include grinding away the carrier polycrystalline SiC substrate.

Grinding away the carrier polycrystalline SiC substrate may further include exposing a surface of the polycrystalline SiC substrate.

At least one embodiment of a device of the present disclosure may be summarized as including: a first polycrystalline SiC substrate including a first surface and a second surface opposite to the first surface; and a second polycrystalline SiC substrate coupled to the second surface of the first polycrystalline SiC substrate.

The first polycrystalline SiC substrate may have a first sidewall; and the second polycrystalline SiC substrate may have a second sidewall substantially coplanar with the first sidewall.

The first polycrystalline SiC substrate may have a first coefficient of thermal expansion (CTE); the second polycrystalline SiC substrate may have a second CTE; and the first CTE may be substantially equal to the second CTE.

The second polycrystalline SiC substrate may include a third surface that faces away from the first surface.

The second polycrystalline SiC substrate may include a third surface facing away from the first polycrystalline SiC substrate, and the third surface of the second polycrystalline SiC substrate may have a roughness less than or equal to 0.5 nm (5 angstroms, Å).

In view of the discussions herein, the present disclosure is directed to a polycrystalline SiC base substrate that is formed and then used or utilized to direct bond another polycrystalline SiC substrate to the polycrystalline SiC base substrate or form another polycrystalline SiC substrate on the polycrystalline SiC base substrate. For example, in at least one embodiment, the another polycrystalline SiC substrate is formed on or bonded to the polycrystalline SiC base substrate by forming or bonding the polycrystalline SiC substrate to a respective surface of the polycrystalline SiC base substrate. This direct bond or formation of the another polycrystalline SiC substrate on the respective surface of the polycrystalline SiC base substate may be utilized to replace standard formation processes of SiC substrates or polycrystalline SiC substrates that are known within the SiC device industry.

In view of the above discussions herein, polycrystalline SiC substrates known within the semiconductor industry may be made by CVD *(i.e.,* chemical vapor deposition) growth or PVT (*i.e.,* physical vapor transport) growth processes or techniques. Sintered substrates are known within the semiconductor industry and may have a lower density compared to the CVD or PVT produced substrates, which may have the same or similar densities as single crystal (*e.g.,* monocrystalline) silicon carbide (SiC) substrates known within the semiconductor industry. To grow the CVD and PVT substrates, a graphite substrate is used as starting substrate (*e.g.,* carrier or base substrate). As discussed herein, this gives rise to several problems, the main problem is stress and strain induced by different thermal expansions of the graphite and the grown silicon caribide (SiC). This difference in thermal expansion leads to large warpage, cracking, or additional complications (*e.g.,* other types of mechanical defects) increasing cost to process the material (*e.g.,* waste costs and decreased yield). The graphite also needs to be completely removed and cannot be kept on the backside of the polycrystalline silicon carbide (SiC) substrate, which makes it a requirement to always manufacture rather thick layers on the graphite substrate. This thick layer manufacturing requirement increases costs to the process to avoid mechanical defects propagating within the polycrystalline SiC substrate formed on the graphite substrate when removing the graphite substrate from the polycrystalline SiC substrate. Whereas the embodiments of the present disclosure with respect to forming the polycrystalline SiC substrate 114 of the present disclosure, addresses these issues with respect to utilizing these known formation processes to form respective polycrystalline SiC substrates.

While the above disclosure discusses forming at least one embodiment of the polycrystalline SiC substrate 114 on the surface 110 of the carrier polycrystalline SiC substrate 108 utilizing a CVD process, it may be possible to utilize another SiC substrate formation technique such as a PVT (*i.e.,* physical vapor transport) process or some other suitable process known within the semiconductor industry to form the polycrystalline SiC substrate 114 on the surface 110 of the carrier polycrystalline SiC substrate 108.

The formation of the polycrystalline SiC substrates with formation processes known within the semiconductor industry may result in thermal expansion mismatches that generate mechanical defects (*e.g.,* warpage, cracking, etc.) decreasing yield. The formation processes known within the semiconductor industry may require additional processing steps such as having to remove a starting substrate from a backside surface of the polycrystalline SiC substrate before being incorporated into an electronic device or semiconductor package increasing manufacturing costs. The formation processes known within the semiconductor industry may be limited as the polycrystalline SiC substrate must be manufactured relatively thick such that the likelihood of damage to the polycrystalline SiC substrate is reduced or prevented when the starting substrate is removed from the polycrystalline SiC substrate. The embodiments of the polycrystalline SiC substrate 114 of the present disclosure address these drawbacks and issues with respect to formation processes of polycrystalline SiC substrates known within the semiconductor industry. For example, the embodiments of the polycrystalline SiC substrates 114 as discussed herein may be manufactured to be thinner than those known within the semiconductor industry, may be formed avoiding any thermal mismatch between the embodiment of the polycrystalline SiC substrate 114 and a carrier or starting substrate (*e.g.,* the polycrystalline carrier SiC substrate 108), and may be formed with low bow and warpage. Furthermore, manufacturing the embodiments of the polycrystalline SiC substrate 114 is less expensive than utilizing processes known within the semiconductor industry.

As discussed herein, in at least one embodiment, the present disclosure is directed to forming a stacked structure with a starting substrate of sintered polycrystalline silicon carbide (SiC) with a dense CVD grown polycrystalline silicon carbide layer or substrate on top *(e.g.,* based on the orientation of the starting substrate of the sintered polycrystalline (SiC)) of the starting substrate. The dense CVD grown polycrystalline silicon carbide layer or substrate may have a typical thickness of at least 50-100 micrometers (µm), or equal to 150 micrometers (µm). The CVD grown polycrystalline silicon carbide layer or substrate may then be polished, and a thin layer or substrate of monocrystalline SiC may be bonded to, coupled to, or formed on the CVD grown polycrystalline silicon carbide layer or substrate of the present disclosure. The stacked substrate may then be used for electronic or semiconductor device manufacturing. In some embodiments, this process may include having the sintered substrate removed in a back grinding step.

The present disclosure is directed to at least one embodiment of a stacked structure including a sintered carrier SiC substrate (*e.g.,* the polycrystalline carrier SiC substrate 108) on which a CVD grown SiC layer or substrate (*e.g.,* the polycrystalline SiC substrate 114) is formed or grown. For example, the surface (*e.g.,* the surface 110 of the polycrystalline SiC substrate 108) may be a top surface (*e.g.,* based on the orientation of the sintered carrier SiC substrate) on which the CVD grown SiC layer or substrate is formed or grown on utilizing a CVD *(i.e.,* chemical vapor deposition) process or technique. The CVD grown SiC layer or substrate may have a first density that is equal to a density of a monocrystalline SiC layer or substrate that is later formed on the CVD grown SiC layer or substrate. The sintered carrier SiC substrate may have a lower density than the CVD grown SiC layer or substrate. The CVD grown SiC layer or substrate may have a surface that is polished to have a roughness less than or equal to 0.5 nm (5 angstroms, Å).

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A method, comprising:
forming a carrier polycrystalline silicon carbide, SiC, substrate having a surface, forming the carrier polycrystalline SiC substrate including:
sintering one or more powdered materials to form the carrier polycrystalline SiC substrate; and
forming a polycrystalline SiC substrate on the surface of the carrier polycrystalline SiC substrate, forming the polycrystalline SiC substrate including:
depositing SiC onto the surface of the carrier polycrystalline SiC substrate with a chemical vapor deposition, CVD, process.

2. The method of claim 1, further comprising cooling the polycrystalline SiC substrate and the carrier polycrystalline SiC substrate.

3. The method of claim 1 or 2, wherein the carrier polycrystalline SiC substrate has a first coefficient of thermal expansion, CTE, and the polycrystalline SiC substrate has a second CTE, and the first CTE is substantially equal to the second CTE.

4. The method of anyone of claims 1-3, further comprising polishing a surface of the polycrystalline SiC substrate facing away from the surface of the carrier polycrystalline SiC substrate to have a roughness less than or equal to 0.5 nm.

5. The method of anyone of claims 1-4, further comprising removing the polycrystalline SiC substrate from the carrier polycrystalline SiC substrate, in particular wherein removing the polycrystalline SiC substrate from the carrier polycrystalline SiC substrate includes grinding away the carrier polycrystalline SiC substrate and exposing a surface of the polycrystalline SiC substrate.

6. The method of claim 5, further comprising forming one or more semiconductor layers on a surface of the polycrystalline SiC substrate, wherein the one or more semiconductor layers includes at least one monocrystalline layer, wherein the at least one monocrystalline layer is in particular a monocrystalline SiC layer.

7. A device, comprising:
a first polycrystalline SiC substrate including a first surface and a second surface opposite to the first surface, the first polycrystalline SiC substrate having a first cubic structure; and
a second polycrystalline SiC substrate coupled to the second surface of the first polycrystalline SiC substrate, the second polycrystalline SiC substrate has a second cubic structure.

8. The device of claim 7, wherein:
the first polycrystalline SiC substrate has a first sidewall; and
the second polycrystalline SiC substrate has a second sidewall substantially coplanar with the first sidewall.

9. The device of claim 7 or 8, wherein:
the first polycrystalline SiC substrate has a first coefficient of thermal expansion, CTE;
the second polycrystalline SiC substrate has a second CTE; and
the first CTE is substantially equal to the second CTE.

10. The device of anyone of claims 7-9, wherein the second polycrystalline SiC substrate includes a third surface that faces away from the first surface.

11. The device of anyone of claims 7-10, wherein the second polycrystalline SiC substrate includes a third surface facing away from the first polycrystalline SiC substrate, and the third surface of the second polycrystalline SiC substrate has a roughness less than or equal to 0.5 nm.

12. A method, comprising:
forming a polycrystalline SiC substrate with a first coefficient of thermal expansion on a first surface of a polycrystalline SiC carrier substrate with a second coefficient of thermal expansion substantially equal to the first coefficient of thermal expansion, forming the polycrystalline SiC substrate includes forming a second surface of the polycrystalline SiC substrate facing away from the carrier polycrystalline SiC substrate; and
after forming the polycrystalline SiC substrate, removing the polycrystalline SiC substrate from the carrier polycrystalline SiC substrate.

13. The method of claim 12, further comprising polishing the second surface of the polycrystalline SiC substrate to have a roughness less than or equal to 2 nm.

14. The method of claim 12, further comprising forming a monocrystalline SiC layer on the second surface of the polycrystalline SiC substrate.

15. The method of claim 14, wherein the polycrystalline SiC substrate has a first density and the monocrystalline SiC layer has a second density substantially equal to the first density, in particular wherein the polycrystalline SiC substrate and the polycrystalline SiC carrier substrate have a cubic structure.
